(19) Europäisches Patentamt
European Patent Office
Office européen des brevets

(11) EP 4 707 920 A1

(12) EUROPEAN PATENT APPLICATION

(43) Date of publication:
**11.03.2026 Bulletin 2026/11**

(21) Application number: **24198911.0**

(22) Date of filing: **06.09.2024**

(51) International Patent Classification (IPC):
***G03F 7/00** (2006.01)* ***G03F 7/004** (2006.01)*

(52) Cooperative Patent Classification (CPC):
**G03F 7/0046; G03F 7/0002**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Epinovatech AB**
**223 63 Lund (SE)**

(72) Inventor: **OLSSON, Martin Andreas**
**223 63 Lund (SE)**

(74) Representative: **Zacco Sweden AB**
**P.O. Box 5581**
**Löjtnantsgatan 21**
**114 85 Stockholm (SE)**

Remarks:
Amended claims in accordance with Rule 137(2) EPC.

# (54) NANOIMPRINT RESIST

(57) The present inventive concept relates to nanoimprint resist comprising a copolymer obtained from a monomer mixture comprising a first monomer and a second monomer, wherein the first monomer is a fluoride-containing monomer, and, in the copolymer, the first monomer is a repeating unit by $n_1$, and the second monomer is a repeating unit by $n_2$; and a photoinitiator.

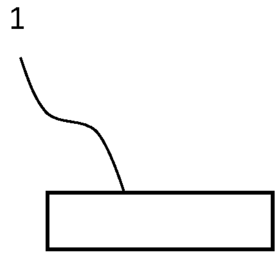


Figure 3

EP 4 707 920 A1

## Description

Technical field of invention

The present inventive concept relates to a nanoimprint resist and a method for nanoimprinting using a nanoimprint resist.

Technical background

Nanoimprint lithography (NIL) is a known method of fabricating objects having patterns in nanometer scale. Nanoimprint lithography (NIL) was introduced by Chou in 1995. The technique uses mechanical deformation of a polymer substrate under pressure and elevated temperature, by means of a stamp having a desired pattern that is pressed against the polymer substrate. A pattern is created by mechanical deformation of a polymer substrate often referred to as a nanoimprint resist as a thin-film. The mechanical deformation may be realized by a patterned mold being pressed against the polymer substrate followed by curing or hardening. The thus obtained pattern may then be transferred to an underneath material by means of known pattern transfer processes, such as reactive ion etching. The nanoimprint resist may be a polymer formulation that is cured during imprinting by heat or UV light.

One of the major challenges in NIL is the defect rate due to a large demolding force which causes difficult demolding. The friction on the sidewalls of the mold pattern is generally larger than the adhesion between the mold and the resist. The demolding forces may be reduced by means of a sidewall inclination that reduces friction and facilitate air penetrating into gaps created during demolding. In particular, deformed patterns may be formed when the mold is released from the nanoimprint resist causing demolding lines.

In the document, Journal of Vacuum Science & Technology B, 2007. 25(6): p. 2430-2434, addition of fluorine surfactant to a mold surface is described. A common alkylsiloxane for surface modification of the contact angle of silica stamps is octadecyl-tri-chlorosilane with a trichlorosilane group that forms a 2 nm thin layer. Hydroxyl groups on the silica surface is necessary to anchoring chlorosilane groups on the silica stamp surface. The document Nanotechnology 27, 2016, 155301 describes a fluorinated ethylene-propylene as an alternative to Polydimethylsiloxane (PDMS) e.g. PTFE (polytetrafluoroethylene).

The document, Journal of Vacuum Science & Technology B: Microelectronics and Nanometer Structures Processing, Measurement, and Phenomena. 25, 2430 (2007), relates to reducing the interfacial surface energy by simply adding a fluorinated alkyl surfactant to the resist. Furthermore, it describes sol-gel surface modification of molds by tridecafluoro-1,1,2,2-tetrahydrooctyltrichlorosilane.

The document J. APPL. POLYM. SCI. 2015, DOI: 10.1002/APP.41317 relates to the use of surface modification to improve demolding in nanoimprint lithography. In particular the document describes a sol-gel reaction to modify a silane-based polymer and a PET film surface with a fluorine monomer with (tridecafluoro-1-octyl)triethoxysilane (FTES) contents via cationic polymerization mechanism. Sol-gel modification of stamps is used to fluorinate nanoimprint stamps. The cationic polymerization was specifically chosen instead of radical polymerization, as radical polymerization would be affected by atmospheric oxygen and hence could be harmful to the nanopatterned surface whereas the effect of oxygen is negligible in the case of cationic polymerization. An increase in FTES decreased the modulus and tensile strength. The surface of the film without FTES was hydrophilic whereas it was hydrophobic with a contact angle above 90° with FTES content above 5 mol%. The document describes an optimum demolding with 20 mol % of the fluorinated monomer. Excessive amount of 30 mol %, may be detrimental to the NIL process because the desired physical properties of the substrate would be degraded.

Summary of the invention

It is a particular object of the invention to avoid or minimize deformed patterns of nanoimprint resists. The inventor has realized that a nanoimprint resist may be provided that is advantageous to alleviate the issues of demolding lines. According to the invention the glass transition temperature may be lowered by providing a copolymer nanoimprint resist that also is resistant to oxygen plasma etching in order to provide improved resist molding profiles after plasma etching of the residual resist layer.

Another object of the invention is to reduce the reaction time and ultimately the fabrication time of nanoimprint lithography for higher resolution and higher throughput with less defect density.

According to a first aspect, a nanoimprint resist is provided. The nanoimprint resist comprises a copolymer obtained from a monomer mixture comprising a first monomer and a second monomer, wherein the first monomer is a fluoride-containing monomer, and, in the copolymer, the first monomer is a repeating unit by $n_1$, and the second monomer is a repeating unit by $n_2$.

By comprising the copolymer, a nanoimprint resist may be provided in suitable shape, and, in addition, may be

provided in a form that allows curing during imprinting to allow manufacture of a durable structure with stable imprints.

By comprising the first monomer and the second monomer, tailoring of the copolymer is allowed, i.e. to lend the nanoimprint resist desirable properties. In particular, the first monomer and the second monomer and their respective repeating units by $n_1$ and $n_2$ allows provision of desirable anti-sticking properties of the nanoimprint resist, resulting in sufficiently low adhesion between the resist and a mold to reduce or minimize deformation of the nanoimprint.

The nanoimprint resist allows easy release of the mold from the nanoimprint resist, and thereby contributes to avoiding or minimizing deformation of the imprinted pattern. This may, at least in part, be attributed to reduced adhesion achieved with the nanoimprint resist as described herein.

The first monomer may be vinylidene fluoride.

The first monomer may be selected from the monomer group consisting of tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene and derivatives thereof.

The second monomer may be methyl methacrylate or a derivate of methyl methacrylate.

The copolymer may be poly(chlorotrifluoroethylene)-graft-(methyl pyridinium)-block-poly(methyl methacrylate).

The first monomer may be present in an amount of 1-10%, by weight of the nanoimprint resist.

The nanoimprint resist may comprise a photoinitiator. At least one of the first monomer and the second monomer may be configured for crosslinking. Thereby, photoinitiated polymerization or cross-linking may be efficiently initiated. For example, at least one of the first monomer and the second monomer may have side groups, substituents or bonds that allows crosslinks to form. Crosslinking may occur internally within the polymer comprising the monomer, or between different polymers. The photoinitiator may be present in an amount of 10-30% by weight of the nanoimprint resist. The photoinitiator may comprise a benzoyl moiety. The photoinitiator may be selected from the group of compounds consisting of benzoin ethers, dialkoxy acetopphenones, hydroxy alkyl ketones, acyl phosphine oxides, amino ketones, benzophenone, thioxanthones and 1,2-diketones.

The molecular weight of the copolymer may be 120 kg $mol^{-1}$ or below.

According to a second aspect, there is provided a method for producing a nanoimprint copolymer resist. The method comprising providing a first and a second monomer, wherein the first monomer is a fluoride-containing monomer and the second monomer is methyl methacrylate or styrene. The method further comprises providing an initiator; initiating polymerization of a first polymer by the initiator with said first monomer; and initiating polymerization of a second polymer by the initiator with said second monomer. The method further comprises mixing the propagated polymers with a polymer chain terminator.

The fluoride-containing monomer may be selected from the monomer group consisting of tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene and derivatives thereof. Thereby, radical polymerisation may be realised.

The initiator may be an ionic initiator and selected from the group consisting of aluminum trichloride, titanium tetrachloride, boron trifluoride, and tin tetrachloride. Thereby, cationic polymerization may be realised.

The ionic initiator may be polystyryl lithium or n-butyl lithium. For example when the initiator is an ionic initiator, the polymer chain terminator may be dichloromethane.

The first monomer may chlorotrifluoroethylene. Thereby graft polymerisation may be realised. If the polymer chain terminator is dichloromethane and/or the first monomer is chlorotrifluoroethylene, iodomethane may be used to configure methyl methacrylate for grafting of chlorotrifluoroethylene. Thereby, graft polymerisation may efficiently be realised.

The first monomer may be present in an amount of 1-10% by weight of the nanoimprint resist.

The method may further comprise dissolving the first monomer, the second monomer, and the initiator in a solvent, wherein the solvent is a mixture of: at least one solvent selected from the gropup consisting of acetonitrile, dimethyl formamide, tetrahydrofurane, and dimethylacetamide; and at least one fluoride-containing solvent selected from the group consisting of dichlorodifluoromethane, trichlorofluoroethane, perfluorooctyl bromide, and perfluorooctane.

The above-mentioned features of the first aspect, when applicable, apply to the second aspect as well. In order to avoid undue repetition, reference is made to the above.

According to a third aspect, there is provided a nanoimprint system for nanoimprinting. The system comprising: a substrate spin-coated with a nanoimprint resist according to the first aspect; and a mold, having a pattern, for contacting with said nanoimprint resist. The mold is configured for pressing the mold in contact with the nanoimprint resist and for subsequent release of the mold from contact with the nanoimprint resist.

Spin-coating allows a thin layer of the copolymer to be presented, and thereby allows provision of a nanoimprint resist in form of a thin layer.

The copolymer as defined by the first aspect lends the nanoimprint resist suitable and desirable anti-sticking properties. Thereby, the separating the mold from the nanoimprint resist may be conducted with reduced, or minimized, defects to the imprinted pattern.

Further, with the system, desirable anti-sticking properties of the nanoimprint resist may be achieved. In addition, risks associated with defects of an imprinted pattern is reduced.

The nanoimprint system may further comprise a UV light source. Thereby, UV-initiated polymerization is provided for.

The pattern may comprise a nanostructured topological pattern in the range of 1-100 nm.

The contacting of the mold with the nanoimprint resist may be performed by pressing or stamping the mold in contact with the nanoimprint resist.

The nanoimprint system may comprise radically initiated crosslinking the copolymer of the nanoimprint resist simultaneous with or following the contacting.

A possible advantage is that nanoimprint lithography at lower temperatures is allowed which reduces thermal expansion of the nanoimprint resist. Furthermore, a nanoimprint copolymer resist may be provided with a lower glass transition temperature that reduces the shrinkage of the nanoimprint resist upon cooling.

The contacting the mold with the nanoimprint resist may be pressing or stamping the mold in contact with the nanoimprint resist. During pressing of the mold against the nanoimprint resist, the resist is displaced or extruded into the pattern of the mold. A high aspect ratio of the mold exposes the polymer to a higher shear stress.

The mold may be a type of stamp, or other suitable tool or object that carries a pattern and can be used as a stamp or mold to transfer the pattern to the nanoimprint resist. The mold may be a stamp.

Crosslinking the copolymer of the nanoimprint resist may be simultaneous with or following the contacting.

Crosslinking the copolymer of the nanoimprint resist simultaneous with or following the contacting, may further be preceding the separating the mold from the nanoimprint resist.

The above-mentioned features of the first or second aspects, when applicable, apply to the third aspect as well. In order to avoid undue repetition, reference is made to the above.

A further scope of applicability of the present disclosure will become apparent from the detailed description given below. However, it should be understood that the detailed description and specific examples, while indicating preferred variants of the present inventive concept, are given by way of illustration only, since various changes and modifications within the scope of the inventive concept will become apparent to those skilled in the art from this detailed description. Hence, it is to be understood that this inventive concept is not limited to the particular steps of the methods described or component parts of the systems described as such method and system may vary. It is also to be understood that the terminology used herein is for purpose of describing particular embodiments only and is not intended to be limiting. It must be noted that, as used in the specification and the appended claim, the articles "a", "an", "the", and "said" are intended to mean that there are one or more of the elements unless the context clearly dictates otherwise. Thus, for example, reference to "a unit" or "the unit" may include several devices, and the like. Furthermore, the words "comprising", "including", "containing" and similar wordings do not exclude other elements or steps.

## Definitions

The term "crosslinking" should be understood as the process of forming covalent bonds or relatively short sequences of chemical bonds to join two polymer chains together.

The term "resist" shall have the meaning of a thin layer used to transfer a pattern to a substrate which it is deposited upon.

The term "initiator" should be understood as a source of any chemical species that reacts with a monomer to form an intermediate compound capable of linking successively with a large number of other monomers into a polymeric compound.

The term "propagated" should be understood as a polymer increasing its chain length.

The term "monomer" should have the meaning of a monomer, a molecule of any of a class of compounds, that can react together with other monomer molecules to form a larger polymer chain or three-dimensional network.

The term "photoinitiator" shall be understood to be one or more molecules that absorb photons upon irradiation with light and form reactive species out of the excited state, which initiate consecutive reactions. The initiating species may be radicals, cations, or anions and the photoinitiator should then be understood as a "radical photoinitiator", a "cation photoinitiator", and an "anion photoinitiator", respectively.

The term "demolding" should be understood as the separation of stamp and resist.

It will be understood that polymers, such as the copolymer, herein, is sometimes described or discussed in terms of the monomers used for manufacturing of the polymer, such as the copolymer. The copolymer may, for example, be discussed using the term first monomer or second monomer, and it shall be understood that reference is made to monomers made for manufacturing of the copolymer, or to repeating units of the copolymer, derived from or relating to the first monomer or the second monomer.

Brief description of the drawings

The above and other aspects of the present inventive concept will now be described in more detail, with reference to appended drawings showing variants of the inventive concept. The figures should not be considered limiting the inventive concept to the specific variant; instead, they are used for explaining and understanding the inventive concept. Like reference numerals refer to like elements throughout.

Figure 1 and figure 2 both illustrates nanoimprint defects for comparative purposes.
Figure 3 illustrates a nanoimprint resist.
Figure 4 illustrates a schematic view of a copolymer where each of the monomers are represented as beads of a polymer chain.
Figure 5 illustrates the method of an aspect.
Figure 6a, figure 6b, and figure 6c illustrate a method and a nanoimprint resist.
Figure 7(a) illustrates the pressure and temperature conditions during a thermal nanoimprint lithography process.
Figure 7(b) illustrates the pressure and temperature conditions during a UV nanoimprint lithography process.
Figures 8(a) and 8(b) illustrates copolymer glass transition during a nanoimprint lithography process.

Detailed description

The present inventive concepts will now be described more fully hereinafter with reference to the accompanying drawings, in which variants of the inventive concepts are shown. This inventive concept may, however, be implemented in many different forms and should not be construed as limited to the variants set forth herein; rather, these variants are provided for thoroughness and completeness, and fully convey the scope of the present inventive concept to the skilled person.

Nanoimprint resists according to the first aspect provide for anti-sticking properties between the nanoimprint resist and a mold used during imprinting. Thereby, the mold may be released from the nanoimprint resist with reduced risk, or totally avoiding risk, of producing defects of the pattern transfer from the mold pattern to the nanoimprint polymer. The importance of anti-sticking properties may be illustrated with reference to comparative figures 1 and 2, which illustrates nanoimprint defects in the form of stripes 54 that were formed during a release process of a nanoimprint mold sticking to a nanoimprint resist manufactured from conventional polymer after UV curing. It shall be realized that such defects or stripes may be highly disadvantageous as they may have severe negative effects, for example on any following pattern transfer.

The inventor has realized that a nanoimprint resist comprising the copolymer as defined by the aspects discussed herein, is associated with anti-sticking properties. Anti-sticking, as used herein, intends to include and describe, as a result of at least a property of the nanoimprint resist, provision of reduced adhesion to the mold, or other type of tool, used in the imprinting, such that the imprinted nanoimprint resist and the mold may be released from each other essentially without undesired deformation of the imprinted nanoimprint resist. Anti-sticking may, alternatively, be referred to as reduced-sticking, as compared to a conventional used resist as used in nanoimprinting, for example, as compared to a resist made from polymethylmethacrylate (PMMA).

A nanoimprint resist as defined by aspects herein, may be used for nanoimprint lithography and facilitate release of the nanoimprint mold without resulting defects of the pattern of the imprinted nanoimprint resist.

With reference to figure 3, a nanoimprint resist 1 will now be discussed. The nanoimprint resist 1 comprises a copolymer obtained from a monomer mixture comprising a first monomer and a second monomer, wherein the first monomer is a fluoride-containing monomer, and, in the copolymer, the first monomer is a repeating unit by $n_1$, and the second monomer is a repeating unit by $n_2$.

The first monomer may be vinylidene fluoride. The second monomer may be methyl methacrylate (MMA) or a derivate of methyl methacrylate. MMA is a readily available monomer with low cost and essentially unlimited shelf life. Polymers made from MMA, PMMA, can be easily dissolved in suitable solvent, eg. Propylene glycol methyl ether acetate (PGMEA), which allows desirable film thickness during spin-coating.

PMMA may suitably be combined with a stamp or mold made from $SiO_2$ stamp, resulting from the PMMA polymer having a hydrophilic surface.

The copolymer may be poly(chlorotrifluoroethylene)-graft-(methyl pyridinium)-block-poly(methyl methacrylate).

The monomer mixture may further comprise additional monomers, such as a third monomer. The third, and any optional additional monomers, may be a monomer which may be described as the second monomer is described herein.

The copolymer may be grafted.

The first monomer may be present in an amount of 1-50%, such as 1-10%, by weight of the nanoimprint resist. At least one of the first monomer and the second monomer may be configured for crosslinking. For example, at least one of the first monomer and the second monomer may have side groups, substituents or bonds that allows crosslinks to form. Crosslinking may occur internally within the polymer comprising the monomer, or between different polymers.

The nanoimprint resist may comprise a photoinitiator. Thereby, photoinitiated polymerization or cross-linking may be efficiently initiated. The photoinitiator may be present in an amount of 10-30% by weight of the nanoimprint resist. The photoinitiator may comprise a benzoyl moiety. The photoinitiator may be any of the compounds benzoin ethers, dialkoxy acetopphenones, hydroxy alkyl ketones, acyl phosphine oxides, amino ketones, benzophenone, thioxanthones or 1,2-diketones. The molecular weight may be less than 120 kg $mol^{-1}$.

At least one of the first monomer and the second monomer may be configured for radical polymerization. Thereby, efficient curing may be realized during imprinting, such as during cross-linking of the copolymer.

The first monomer may be chlorotrifluoroethylene. The second monomer may be methyl methacrylate or a derivate of methyl methacrylate. The chlorotrifluoroethylene monomer may be grafted for cationic copolymerization with e.g. methyl pyridinium. The compound 4-vinylpyridine may first be reacted with dimethylaminoethyl acrylate and iodomethane to provide the grafting monomer for a living polymerization. The grafting of the copolymer with an aromatic polymer may be advantageous to improve the chemical resistance to oxygen plasma etching.

It has been unexpectedly realized that such first and second monomers, when combined as described herein, provides a nanoimprint resist which during nanoimprinting minimizes or reduces risks of sticking between the nanoimprint resist and a mold, and reduces risks of deformation of the imprinted pattern.

The glass transition temperature of the polymer may be configured, or controlled, by a molecular weight by said repetitions $n_1$ and $n_2$

The ratio of monomer repetitions $n_1$ and $n_2$ may be configured for providing anti-sticking, in other words, suitable selection of $n_1$ and $n_2$, contributes to anti-sticking properties of the nanoimprint resist. With reference to figure 4 a portion of the copolymer, of the nanoimprint resist, is schematically illustrated. In the illustration, the copolymer has a ratio of $n_1$:$n_2$ within the range of 1:10 to 1:20, although this is one example and other ratios and structures of the copolymer is possible. $n_1$ relates to the first monomer 50, which is illustrated using squares, and $n_2$ relates to the second monomer 52, which is illustrated using circles. The first monomer 50 and the second monomer 52 may be selected as discussed herein. For the particular illustrated example, the ratio is 1:15, and the illustrated example is provided to improve understanding of the ratio $n_1$:$n_2$. The ratio of 1:15 is within the range which provides desirable anti-sticking properties with reduced or minimal risks of defects of the imprinted pattern.

It shall be realized that the first and the second monomers may be repeated within the copolymer to provide a molecular weight of the copolymer of 10 000 g/mol or less, for example within the illustrated ratio $n_1$:$n_2$, or other ratios. The ratio of n1 and n2 may be configured for di-block-co-polymer or a grafted di-block-co-polymer.

With reference to figure 5 an aspect relating to a method 100 for nanoimprinting using a nanoimprint resist 1 as defined by the first aspect will now be described. The method 100 comprises: providing 102 a layer of the copolymer on a substrate by spin-coating, thereby providing the nanoimprint resist; contacting 104 a mold, having a pattern, with the nanoimprint resist, wherein an imprint of the pattern is provided on a surface of the nanoimprint resist; crosslinking 106 the copolymer of the nanoimprint resist; and separating 108 the mold from the nanoimprint resist, wherein a nanoimprint defined by the pattern is provided on the nanoimprint resist.

The method 100 and the nanoimprint resist 1 will be further explained and illustrated with reference to figures 6a to 6c. The spin-coating is a suitable way of providing a thin layer 2 of the copolymer 4. Even though it shall be understood that a thin layer may not always be necessary or sought for a nanoimprinted object, it is often desirable, and herewith made possible. The spin-coating, as discussed herein is conducted on a substrate 6, which suitably may function to allow the manufacturing and spin-coating of the nanoimprint resist. Further, the substrate 6 may function as an abutment for a mold used for nanoimprint. The substrate 6 may be selected to allow removal of the nanoimprinted resist after imprinting. For such a purpose, the substrate 6 may have anti-sticking properties in relation to the nanoimprint resist. Further, the substrate may be a substrate or object which may be further subjected to a pattern transfer process, such as, for example, reactive ion etching, wherein the imprinted pattern of the nanoimprint resist 1 is transferred to the substrate.

Contact between the thin layer of copolymer 4 and a mold may efficiently be employed for transfer of a pattern 12 from the mold 8 to the copolymer 4 or the nanoimprint resist 1, thereby allowing provision of a nanoimprint resist in form of a thin layer having a nano-scaled imprint defined by the mold 8. The mold 8 is schematically illustrated in figure 6a, with nano-scaled protrusions 10 defining the pattern 12. The protrusions 10 or the pattern may have one dimension, such as a width, depth or length in the nano-scale range. Figure 6b illustrates the mold 8 during contacting 104 the mold with the nanoimprint resist 1. At this point, the crosslinking 106 the copolymer 4 of the nanoimprint resist 1 may be conducted or initiated. This may be achievable, for example, by one or more of the first monomer and the second monomer being configured for radical polymerization and subjected to radical polymerization conditions. Figure 6c illustrates separation 108 of the mold 8 from the nanoimprint resist 1, which may be conducted after initiation or completion of the crosslinking 106, wherein a nanoimprint defined by the pattern 12 is provided on the nanoimprint resist. Resulting from the pattern 12 having nanostructured topological patterns, for the illustrated example in form of protrusions in the nanometer range, provides the imprinted nanoresist with structures in the nanometer scale. It shall be realized, that although these examples illustrate protrusions from the mold, the mold may also be provided with e.g. recesses, which also would have transferred a pattern to the nanoresist. Nanostructured topological patterns may comprise structures defined inwards or outwards from

a surface of the nanoimprint and having at least one dimension, such as, for example, a height, width, or length dimension, in a sub one micrometer range, for example in the range 1-900 nanometers.

The copolymer as defined by the first aspect lends the nanoimprint resist suitable and desirable anti-sticking properties. Thereby, the separating 108 the mold 8 from the nanoimprint resist 1 may be conducted with reduced, or minimized, defects to the imprinted pattern.

The contacting the mold with the nanoimprint resist may be pressing or stamping the mold in contact with the nanoimprint resist.

The crosslinking the copolymer of the nanoimprint resist may be simultaneous with and/or following the contacting.

The crosslinking the copolymer of the nanoimprint resist simultaneous with or following the contacting, may further be preceding the separating the mold from the nanoimprint resist.

Stress during the demolding process of the stamp is generated due to shrinkage of the resist in the UV curing step and also adhesion and friction at the stamp/resist interface in the subsequent demolding step.

The resolution of nanoimprint lithography is at least in part determined by the mechanical strength of the mold and polymer. When the polymer chains in the matrix is completely random the polymer is amorphous. As the molecular motion in an amorphous polymer increases the polymer goes through a glassy state to a rubberlike state until finally it becomes molten.

With reference to Figure 7(a) and Figure 7(b) the molding and demolding during nanoimprint lithography processes according to examples will be described. As illustrated in Figure 7(a), relating to a thermal nanoimprint lithography process, both the stamp and the sample may be heated to the imprint temperature. The pressure on the stamp against the nanoimprint resist and the substrate is applied and maintained during the cooldown until the glass transition temperature $T_g$ is reached. Continuing to maintain the pressure during the cooldown provides for a good pattern definition. The imprint time is the time during highest temperature and highest pressure. Demolding is typically recommended at or around $T_g$ where the polymers are elastic to mechanical stresses. During separation of the surface of the mold and the surface of the resist, the internal surfaces are transformed to external surfaces interfacing with air. The pull-off force is inversely proportional to the square root of the effective pattern radius or the pattern width. Hence, it should be understood that a 5-100 nm linewidth is more challenging for nanoimprint lithography than larger linewidths of 1-10 micron. The demolding force further increases with the aspect ratio of the pattern such as for pattern transfer of etching nanopillars that is particularly challenging. A typical process may include 40-100 bar (580-1450 psi), and a temperature of 30-100°C above the glass transition temperature $T_g$. With such a pressure, air bubble defects, if imprint occurs in air, may be avoided. At such temperatures, above the $T_g$, the polymer chains may move cooperatively, as transition occurs from a glassy state to a rubber-like state hardness and elasticity of the polymer is favorable. The optimal demolding temperature of PMMA, having a Tg at 110°C, may be chosen at around 70°C. The viscosity of the copolymer varies as $\eta \sim M$ to $M^{3/4}$ where M is the molecular weight of the copolymer. Molding of the nanoimprint resist may be performed with a low shear rate i.e. with a copolymer with a low viscosity. Above the $T_g$ the heated resist may flow and fill the template cavities under applied pressure. The shear stress $\tau = \eta \frac{d\gamma}{dt}$ where $\frac{d\gamma}{dt}$ is the shear rate and $\eta$ is the viscosity. A low molecular weight of the copolymer does not affect the glass transition temperature of the copolymer. The viscosity of the copolymer may therefore be low as the polymer chain mobility has a cubic dependence on the polymer chain length around the glass transition temperature for moderately long chains. One advantage of the example is that the copolymer may be able to adapt to the mold pattern with a high fidelity with a shorter relaxation time. This may reduce the shear stress during molding and hence the creep behavior of the nanoimprint resist.

With reference to Figure 7(b) the pressure and temperature conditions during a UV nanoimprint lithography process according to an example is depicted. During the molding the nanoimprint resist is UV cured and a photoinitiator induces radical polymerization of the nanoimprint resist. As the crosslinking density of the nanoimprint resist is increases the glass transition temperature from a $T_{g1}$ to a $T_{g2}$ of the nanoimprint that is elevated above the molding temperature to stabilize a nanostructure in the nanoimprint resist. As depicted the $T_g$ of the copolymer may be lower than room temperature such that no additional heating is required that may cause thermal expansion of the nanoimprint resist. The demolding occurs as the pressure is released while the nanoimprint copolymer resist has increased its glass transition temperature by crosslinking. The time-dependent plastic flow of the nanoimprint resist under the conditions of constant load or stress is commonly called as creep. The creep deformation as demolding lines may be reduced by keeping the mold pressed against the nanoimprint resist only a short time. When the nanoimprint resist is exposed to tensile stress it first behaves elastic up to a critical stress level. Additional stress may cause a plastic flow after under long-term exposure to high levels of stress that are typically below the yield point of the material. Creep is more severe in materials that are subjected to elevated temperature for long periods. Furthermore, lowering the $T_g$ of the nanoimprint resist is beneficial in order to reduce creep deformation as the creep increases with processing at elevated temperatures while pressing the mold. Furthermore, creep deformation of the copolymer may be reduced by increasing the crystallinity.

With reference to Figure 8(a) and Figure 8(b) the copolymer may be semicrystalline. The copolymer may be

semicrystalline with a crystallinity of 1-30% where the fluoride-polymer contributes to a crystalline phase that may form e.g. lamellae or a crystalline phase as particles. The modulus of the polymer resist thin-film layer may be increased by copolymerization to withstand higher stress without straining the thin-film during demolding due to high demolding force. The crystallinity of a polymer may be configured by the chain rigidity and copolymerization. The degree of crystallinity of the polymer affects the mechanical response in the temperature range $T_g$ to the melting temperature Tm and below $T_g$ the effect on the modulus is small. The modulus of semicrystalline polymer may be directly proportional to the degree of crystallinity and is independent of temperature if the crystalline order remains unchanged. For a high degree of crystallinity and high bulk modulus of the copolymer it should be symmetrical, linear and unbranched.

In a non-limiting example of aspects discussed herein the copolymer may be linear and the polymerization may be ionic in order to provide a high degree of crystallinity. Dipolar interaction between functional groups such as -CN creates stronger interactions than hydrogen bonding that also improves the crystallinity. Chain rigidity also favors crystallinity such as inclusion of aromatic rings in the chain. According to one embodiment of the invention the crystallinity of the polymer resist PMMA may be modified by copolymerization.

Imprinting uniformity may be considered dependent on the pattern density across the wafer and the demolding force is higher for a larger vertical stamp depth. Smaller patterns may require longer relaxation times. The necessary relaxation time of the polymer scales as directly proportional to the cube of the chain length or as the square of the molecular weight. Hence, it may be preferred that the molecular weight is low for small polymer nanostructures, such that the polymer chains can deform without long molding times. Below $T_g$ crosslinking has little impact on creep behavior that depends on temperature and the cross-link density. The resist should be sufficiently viscoelastic to retain the fidelity of the micro/nanostructure during the imprint process.

In the following the demolding force will be described and how the surface energy of the nanoimprint copolymer resist may provide anti-sticking to the mold during demolding. The adhesion energy the polymer resist and the mold can be described as

$$E_{adhesion} = (\gamma_p + \gamma_s) - \gamma_{ps}$$

where $\gamma_p$ is the surface energy of the polymer resist in air and $\gamma_s$ is the surface energy of the mold in air whereas $\gamma_{ps}$ is the surface energy of the intact interface. The interfacial surface energy $\gamma_{ps}$ may be approximated as $\gamma_{ps} \approx \left(\sqrt{\gamma_p} - \sqrt{\gamma_s}\right)^2$.

The contact angle β, can be approximated by $\gamma_L \cos \delta \approx \gamma_S - \gamma_{SL}$, where $\gamma_L$ is liquid surface tension, $\gamma_S$ is the surface energy of the solid, and $\gamma_{SL}$ is the interfacial surface energy of the solid surface to the liquid.

The adhesion force, $F_{adhesion} = \left(\frac{3}{2}\pi \cdot E_{adhesion} K R^3\right)^{\frac{1}{2}}$ where K is the bulk modulus of the copolymer, and R is the effective radius of the interface. It was found by the inventor that lowering the surface energy of the nanoimprint resist reduces the adhesion force. Hence, it should be understood that there is a tradeoff between the nanoimprint resist adhesion to the substrate and the adhesion to the mold.

The glass transition temperature, $T_g$, of the cured nanoimprint resist by crosslinking may be configured by the crosslink density of the copolymer i.e. dependent on available side-chain groups of the backbone of the copolymer.

Cross-linking of the copolymer may be initiated by UV curing or by thermal treatment. For UV curing a cross-linking of the nanoimprint resist may be performed by one or more cross-linking compounds. The crosslinking compounds may be derivatives of methylenebisacrylamide or derivatives of ethylene glycol di(meth)acrylate. The crosslinking agent may be any of the compounds N,N'-Methylenebisacrylamide; N,N'-(1,2-Dihydroxyethylene)-bisacrylamide; N-(1-Hydroxy2,2-dimethoxyethyl)acrylamide; divinylbenzene or diisocyanate.

During curing of the copolymer, shrinking occurs as the Lennard-Jones interaction between the polymer chains is converted to dense covalent bonds. In order to reduce the shrinkage stress of the polymer the crosslinking compound may be added to the resist in a range of 10-30 %, by weight of the nanoimprint resist.

The photoinitiator, which may be a radical photo initiator, may comprises a benzoyl moiety. The radical photoinitiation may occur either by hydrogen abstraction or cleavage. Alpha-cleavable photoinitiators may be photo initiators selected from the group consisting of benzoin ethers, dialkoxy acetopphenones, hydroxy alkyl ketones, acyl phosphine oxides, amino ketones. Non-cleavable photoinitiators may be photo initiators selected from benzophenone, thioxanthones or 1,2-diketones. The radical photoinitiator may be any of the Irgacure, Lucirin , Esacure, Cyracure, Deacure.

The molecular weight of the copolymer may be less than 120 kg $mol^{-1}$, whereby a low surface energy and/or a low viscosity of the nanoimprint resist copolymer is provided.

The solvent for radical polymerization of the nanoimprint copolymer may be a mixture of solvents selected from

the list consisting of acetonitrile, dimethyl formamide, tetrahydrofurane, or dimethylacetamide, and a fluoride-containing solvent from any of the solvent's dichlorodifluoromethane, trichlorofluoroethane, perfluorooctyl bromide, or perfluorooctane. An advantage of using a mixture of solvents may be that the solubility of the monomers may be adapted, thereby allowing obtaining lower molecular weights by fine-tuning the solubility.

There is provided a method for providing a nanoimprint copolymer resist comprising: providing a first and a second monomer; the first monomer is a fluoride-containing monomer and the second monomer is methyl methacrylate or styrene, The method further comprises providing an initiator; initiating polymerization of a first polymer by the initiator with the first monomer; initiating polymerization of a second polymer by the initiator with the second monomer; and mixing the propagated polymers with a polymer chain terminator.

The fluoride-containing monomer may be selected from the monomer group consisting of tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene and derivatives thereof. Thereby, radical polymerisation may be realised.

The first fluoride-containing monomer may have a side group that is an electron-donating group of -CH3, -OR, and -OCOCH3, wherein the second monomer is methyl methacrylate.

The first fluoride-containing monomer may have a side group that is an electron-withdrawing group of -COOR, -CN, -COCH3, wherein the second monomer is styrene.

The second monomer may be selected from the group of monomers consisting of 2-(monofluoromethyl)prop-2-enenitrile, 2-(monofluoromethyl)prop-2-enoic acid, or 2-(monofluoromethyl)-3-methoxyprop-1-ene, 2-(difluoromethyl)prop-2-enenitrile, 2-(difluoromethyl)prop-2-enoic acid, or 2-(difluoromethyl)-3-methoxyprop-1-ene.

The first monomer may be fluoroethylene vinyl ether, 3-[2-(trifluoromethyl)phenyl]prop-2-enenitrile or 2-fluoro-4-vinylbenzonitrile.

The initiator may be an ionic initiator and selected from the group consisting of aluminum trichloride, titanium tetrachloride, boron trifluoride, and tin tetrachloride. Thereby, cationic polymerization may be realised. The ionic initiator may be polystyryl lithium or n-butyl lithium. For example when the initiator is an ionic initiator, the polymer chain terminator may be dichloromethane.

The first monomer may be chlorotrifluoroethylene. Thereby graft polymerisation may be realised.

If the polymer chain terminator is dichloromethane and/or the first monomer is chlorotrifluoroethylene, iodomethane may be used to configure methyl methacrylate for grafting of chlorotrifluoroethylene. Thereby, graft polymerisation may efficiently be realised.

The first monomer may be present in an amount of 1-10% by weight of the nanoimprint resist.

The method may further comprise dissolving the first monomer, the second monomer, and the initiator in a solvent. The solvent may be a mixture of: at least one solvent selected from the gropup consisting of acetonitrile, dimethyl formamide, tetrahydrofurane, and dimethylacetamide, and at least one fluoride-containing solvent selected from the group consisting of dichlorodifluoromethane, trichlorofluoroethane, perfluorooctyl bromide, and perfluorooctane.

There are various copolymers that can be formed by the two monomer units. The copolymers may, for example, be statistical formed by irregular propagations of two units in a statistical fashion, -ABBAAAAABBAAAAA-, alternating with equimolar quantities of two monomers are distributed in a regular fashion in the chain, with -ABABABAB-, linear block copolymers with a mixed distribution of two units that may contain long sequences of one monomer joined to another block of the second as a linear chain AAAABBBBB-, graft copolymers with nonlinear or branched block copolymers, by attaching chains of one monomer to the main chain of another homopolymer, stereo block copolymers with different tacticity between blocks.

Cationic polymerization may occur by initiation, propagation, and termination.

In contrast to radical polymerization, ionic polymerization is associated with reaction rates that are faster and gives high molecular weight polymer.

Cationic initiation of polymerization is limited to monomers with electron-donating groups that help stabilize the delocalization of the positive charge in the pi-orbitals of the double bond. For example, the stablization of a carbonium ion of the vinyl monomer CH2=CHR, where R is the electron-donating group.

The cationic initiator is an electrophilic initiator that may be a protonic acid. The mechanism of initiation takes place by nucleophile attack of the $H_3O+$ of the dissolved acid.

Lewis acids $AlCl_3$, $TiCl_4$, $BF_3$, $SnCl_4$, or a carbenium ion salts. The Lewis acid may be made active by a co-catalyst as a proton donor. In one example $BF_3$ is used as initiator in hydrous conditions where the reactive species are prepared as

$$BF_3 + H_2O \rightarrow H^+[BF_3OH]^-$$

The activated Lewis acid reacts with vinylidene fluoride by

$$H^+[BF_3OH]^- + CF_2 = CF_2 \rightarrow CF_2C^+[BF_3OH]^-$$

with nucleophile attack of the vinylidene fluoride monomer double bond on the proton $H^+$. Chain propagation continues with

$$CF_2C^+[BF_3OH]^- + CF_2 = CF_2 \rightarrow (CF_2C)CF_2C^+[BF_3OH]^-$$

The reactivity of methyl methacrylate for the formation of an alternating copolymer is the use of a complex with ZnCl2. By adding a Lewis acid the acceptor - Lewis acid complex reacts with conjugated donor molecules. A second way of forming an alternating copolymer is by using a Ziegler catalyst formed from Vanadium, titanium halides, or alkyl aluminum. A third way is copolymerization by formation of a zwitterion as dimeric dipolar species $M_N + M_E \rightarrow {}^{+}M_N - M_E^-$. The polymerization then proceeds by retention of separated charges of the dipole as ${}^{+}M_N - (M_N - M_E)_{n-1} - M_E^-$.

The termination of the cationic polymerization may take place by unimolecular rearrangement of the ion pair as

$$\sim CH_2C^+R_1R_2[SMX_n]^- \rightarrow \sim CH_2CR_1R_2 + H^+[SMX_n]^-$$

A cationic initiator may be a metal alkyl such as organolithium derivative e.g. n-butyl lithium. The first polymerization reaction may be initiated by the ionic initiator polystyryl lithium $(PSt)_x^- Li^+$ as $(PSt)_x^- Li^+ + yM_A \rightarrow (PSt)_x\,(M_A)_y^- Li^+$.

The second polymerization reaction may be initiated as $(PSt)_x\,(M_A)_y^- Li^+ + zM_B \rightarrow (PSt)_x\,(M_A)_y\,(M_B)_z^- Li^+$. For example, dichloromethane may be used to terminate and join the triblock copolymer together as

$$(PSt)_w Li^+ + Cl\,CH_2Cl + (PSt)_x\,(M_A)_y\,(M_B)_z^- Li^+ \rightarrow$$

$$(PSt)_w (M_A)_y\,(M_B)_z^- (PSt)_x + 2LiCl$$

Copolymerization may occur efficiently when either both monomers are highly reactive or both monomers have a low reactivity. The bulkiness of a monomer may also provide steric hindrance of homopolymerization, such that alternating copolymers is formed. For strict alternating sequence of two monomers A and B, it is determined by strong polar and steric effects. Furthermore, the alternation is determined by the relative strengths as a donor-acceptor pair. The distribution of monomer units as alternating, random or as blocks is influenced by differing polarities of the monomers. For example, strong electron acceptors are vinyl compounds with electron-withdrawing substituents such as -COOR, -CN, -COCH3 all decrease the electron density of the double bond in a vinyl monomer relative to ethylene. Strong electron donors are -CH3, -OR, and -OCOCH3 increase the electron density.

As the $T_g$ depends on factors including thermal energy required to move the polymer chains it depends on several factors of rotation about chain links such as chain flexibility of the backbone, molecular structure such as steric effects by additional restriction to rotation, molar mass, and cross-linking and branching. An increase in lateral forces between polymer chains restricts the molecular motion, hence polar side-chain groups increase the $T_g$. Cross-linking of the polymer increases the $T_g$. By increasing the curing time of the resist, by crosslinking the polymer, the demolding force also increases.

The nanoimprint resist may have a weight percentage of the fluoride-containing first monomer that is 1-10%.

The glass transition temperature of the copolymer from monomers A and B may be modified according to the Fox equation $\frac{1}{T_g^{AB}} = w_A \frac{1}{T_g^A} + w_B \frac{1}{T_g^B}$ which is applicable for many vinyl monomers assuming ideal mixing. However, most polymers are inherently immiscible and produce heterogenous blends where the A and B monomers repel each other. Hence, the $T_g^{AB}$ can be estimated to be lower than the weighted average $T_g^{AB} = w_A T_g^A + w_B T_g^B$. The glass transition temperature of the copolymer AB can more specifically be parametrized to the equation:

$$T_g^{AB} = \frac{w_A \frac{1}{T_g^A} + w_B \frac{1}{T_g^B}}{w_A + k w_B} + q w_A w_B$$

The glass transition temperature of poly(vinylidene fluoride) is -37°C. Hence, according to an example, mixing poly(methyl methacrylate) with a $T_g$ of 378 K with poly(vinylidene fluoride) with a $T_g$ of 236K may reduce the Tg of the nanoimprint copolymer resist. For a weight percentage poly(vinylidene fluoride) of 62% the $T_g$ can be lowered to 10°C. However, a large amount of poly(vinylidene fluoride) also may have a negative impact on the adhesion of the nanoimprint resist to the substrate. For a copolymer mixture of 90% poly(methyl methacrylate) and 10% poly(vinylidene fluoride) the $T_g$ is 90°C. For a copolymer mixture of 99% poly(methyl methacrylate) and 1% poly(vinylidene fluoride) the $T_g$ is 103°C. Hence, for a weight percentage of 1-10% of poly(vinylidene fluoride) in e.g. poly(vinylidene fluoride)-block-poly(methyl methacrylate) the glass transition temperature may be 90°C - 103°C without sacrificing adhesion to the substrate.

One advantage of lower glass transition temperature includes that thermal expansion of nanoimprint is reduced and its mismatch to the substrate. Furthermore, a lower glass transition temperature reduces the shrinkage of the nanoimprint resist upon cooling that arise when the Lennard-Jones interaction between polymer chains is replaced by covalent crosslinking upon UV curing.

In a non-limiting example of the invention the nanoimprint resist may be a copolymer that is linear. As one example of the nanoimprint copolymer resist, the monomer A may be metyl methacrylate and the monomer B may have any of the functional groups R as -COOR, -CN, -COCH3. Hence, it may be preferred that the monomer B is 2-(difluoromethyl)prop-2-enenitrile, 2-(difluoromethyl)prop-2-enoic acid, or 2-(difluoromethyl)-3-methoxyprop-1-ene, that forms copolymers with electron donating substituents such as the methyl prop-2-enoate functional group.

For example, the nanoimprint copolymer resist may comprise poly[methyl acrylate - alt - 2-(difluoromethyl) prop-2-enenitrile ], poly[methyl acrylate - alt - 2-(difluoromethyl)prop-2-enoic acid], or poly[methyl acrylate - alt - 2-(difluoromethyl)-3-methoxyprop-1-ene], poly(methyl acrylate) - block - poly(2-(difluoromethyl)prop-2-enenitrile), poly(methyl acrylate) - block- poly(2-(difluoromethyl)prop-2-enoic acid), or poly(methyl acrylate) - block - poly(2-(difluoromethyl)-3-methoxyprop-1-ene).

In another non-limiting example of the invention, the fluoride-containing monomer may be 2-(Trifluoromethyl) acrylic acid, (E)-3-chloro-2-(trifluoromethyl)prop-2-enenitrile or fluoromethyl 2-methoxy-2-fluoro-1-(trifluoromethyl)vinyl ether.

The fluoride-containing monomer may be perfluoroalkyl methacrylate such as 2-(perfluorohexyl)ethyl methacrylate.

In a non-limiting example of the invention the copolymer may be prepared by radical polymerization. The free radical may react with an olefinic monomer that generates a chain carrier that retrain its activity such that the polymer can propagate into a macromolecular chain,

$$R^* + H_2C = CHR_1 \rightarrow RCH_2CHR_1^*$$

The chain-growth of the polymer occurs as

$$RM_n^* + M_1 \rightarrow RM_{n+1}$$

In an example, a method of synthesizing a nanoimprint copolymer resist by radical polymerization is provided. The fluoride-containing monomer may be any of monomers tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene or derivatives thereof.

The homopolymerization of fluoride-containing monomer may be performed by radical polymerization using organic solvents such as peroxides that may act as radical initiator. Solvents may be acetonitrile, dimethyl formamide, tetrahydrofurane, or dimethylacetamide.

The rate of consumption of M1 from the initial reaction mixture has been proposed in accordance with

$$-\frac{d[M_1]}{dt} = k_{11}[M_1][M_1{}^*] + k_{21}[M_1][M_2{}^*]$$

and for M2 it is

$$-\frac{d[M_2]}{dt} = k_{22}[M_2][M_2^*] + k_{12}[M_2][M_1^*]$$

Assuming that radical reactivity is independent of chain length and $k_{21}[M_1][M_2^*] = k_{12}[M_2][M_1^*]$ under steady-state conditions i.e. the polymerization only depends on the nature of the terminal unit, the copolymer equation can be described by the expression:

$$\frac{d[M_1]}{d[M_2]} = \frac{[M_1]}{[M_2]}\left(\frac{r_1[M_1] + [M_2]}{[M_1] + r_2[M_2]}\right)$$

where $r_1 = \frac{k_{11}}{k_{12}}$ and $r_2 = \frac{k_{22}}{k_{21}}$. These quantities may be considered relative reactivity ratios as the ratio of the reactivity of the propagating species with its own monomer to the reactivity of the propagating species with the other monomer.

The equation provides a means of calculating the amount of each monomer incorporated in the chain from a given reaction mixture when the reactivity ratios are known. If monomer M1 is more reactive than monomer M2, it will incorporate more easily into the chain of the copolymer. If $r_1 = r_2 = 1$, , then the copolymer is random.

Furthermore, the copolymerization can also be understood by the quantity $r_1r_2$. In 1947, Price and Alfrey developed a simple scheme to predict reactivity ratios of monomers participating in a free radical copolymerization. They introduced a scheme Q-e, where the polymerization is assigned two parameters Q and e. The parameter Q is dependent on the reaction free energy of the process of adding a radical to a C=C double bond, that furthermore reflect polar effects, whereas the parameter e reflects the electronegativity.

$$r_1r_2 = \exp(-(e_1 - e_2)^2)$$

Radical initiators may be azo compounds such as benzoyl peroxide. Heating benzoyl peroxide may provide phenyl radicals with $CO_2$ as leaving group. Other radical initiators such as $\alpha,\alpha'$-azobisisobutyronitrile may be used that is decomposed by radiation with a wavelength of 360 nm. Alkyl hydroperoxides or hydrogen peroxide may further be used or persulfate $S_2O_8^{2-}$. Radical initiators may also be diisopropyl peroxydicarbonate, lauroyl peroxide benzoyl peroxide or t-butyl peroxyisobutyrate.

The nanoimprint resist may be synthesized using the solvents dichlorodifluoromethane, trichlorofluoroethane, perfluorooctyl bromide, or perfluorooctane.

According to an example, the nanoimprint resist may be a copolymer that is grafted as such and may be provided by ATRP modification of poly(vinylidene fluoride). Poly(vinylidene fluoride) is typically 50-60% crystalline with a glass transition temperature of -35°C. In order to provide a living polymerization of vinyldifluoride for ionic polymerization, the vinyldifluoride may first be grafted by ATRP under catalysis with CuCl or CuBr. In one example of the invention, 4-vinylpyridine monomer may be reacted with methyl iodide to form the ion pair for cationic polymerization. Vinyl difluoride may then be reacted with the cationic 4-vinylpyridine monomer derivative to create a grafted copolymer in a mixture of CuBr or CuCl and toluene at 100°C. A flask with the mixture may be stirred for 24h and then cooled and the copolymer precipated in solvent. The copolymer precipitate may be washed in deionized water and ethanol.

A p-Chloromethyl styrene (PCMS) is a styrene derivative that is susceptible to Lewis acid-assisted cation formation. However, ATRP of PCMS gives non-linear polymers that are branched.

The nanoimprint copolymer resist may be a diblock copolymer or triblock copolymer where the copolymer is prepared by ionic polymerization mechanism.

In one example, the copolymer may be prepared by using polystyryl lithium as ionic initiator of the polymerization reaction of methyl methacrylate or vinylidene fluoride. Furthermore, it is a preferred embodiment that the copolymer is a nanoimprint resist where the copolymer comprises polystyrene configured to provide a soft matrix embedding PMMA crystallites. The copolymer may comprise a crystalline monomer and an elastomeric monomer that is added as a second phase above the Tg of polystyrene, in order to provide a damping with a crystalline polymer matrix in a soft matrix. The second monomer may be methyl methacrylate to provide PMMA crystallites in the copolymer embedded in soft matrix of polystyrene. As the linearity improves the degree of crystallinity that further improves the bulk modulus of the nanoimprint resist.

According to one embodiment of the invention there is provided a nanoimprint system (2000) for nanoimprinting

comprising: a provided substrate spin-coated with a nanoimprint resist; a mold, having a pattern, for contacting (104) with said nanoimprint resist; an UV light source; wherein said mold is configured for pressing 108 said mold into the nanoimprint resist and for release of said mold.

The nanoimprint system may comprise a UV light source. The mold pattern may be a nanostructured topological pattern in the range of 1-100 nm. The contacting of the mold with the nanoimprint resist may be performed by pressing or stamping the mold in contact with the nanoimprint resist. The nanoimprint system may be configured to radically crosslink the copolymer nanoimprint resist simultaneous with or following the contacting of the mold.

## EXAMPLE EMBODIMENTS

In one example embodiment there is provided a method 100 for nanoimprinting using a nanoimprint resist, the method comprising: providing 102 a layer of the copolymer on a substrate by spin-coating, thereby providing the nanoimprint resist; contacting (104) a mold, having a pattern, with the nanoimprint resist, wherein an imprint of the pattern is provided on a surface of the nanoimprint resist; crosslinking 106 the copolymer of the nanoimprint resist; and separating 108 the mold from the nanoimprint resist, wherein a nanoimprint defined by the pattern is provided on the nanoimprint resist. The contacting of the mold with the nanoimprint resist may be performed by pressing or stamping the mold in contact with the nanoimprint resist. The crosslinking the copolymer of the nanoimprint resist is simultaneous with or following the contacting. The crosslinking of the nanoimprint copolymer resist may be is radically initiated cross-linking. The pattern may comprise nanostructured topological patterns.

In another example, there is provided a nanoimprint resist (1) comprising a copolymer obtained from a monomer mixture comprising a first monomer and a second monomer, wherein the first monomer is a fluoride-containing monomer, and, in the copolymer, the first monomer is a repeating unit by n1, and the second monomer is a repeating unit by n2; and a photoinitiator. The first monomer may be vinylidene fluoride. The second monomer may be methyl methacrylate or a derivate of methyl methacrylate. The copolymer may be grafted. The weight percentage of the first monomer may be 1-50%. At least one of the first monomer and the second monomer is configured for crosslinking. The photoinitiator may have a weight percentage in the range of 10-30%. The photoinitiator may comprise a benzoyl moiety. The photoinitiator may be any of the compounds benzoin ethers, dialkoxy acetopphenones, hydroxy alkyl ketones, acyl phosphine oxides, amino ketones, benzophenone, thioxanthones or 1,2-diketones. The molecular weight may be less than 120 kg $mol^{-1}$.

In yet another example, there is provided a method of providing a nanoimprint copolymer resist (1) comprising the steps of: (1001) providing a first and at least one second monomer; said first monomer is fluoride-containing monomer and said second monomer is methyl methacrylate or styrene; (1002) providing an initiator; (1003) initiating polymerization of a first polymer by said initiator with said first monomer; and initiating polymerization of a second polymer by said initiator with said second monomer; and, (1004) mixing said propagated polymers with a polymer chain terminator. The fluoride-containing monomer may be any of the monomers tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene or derivatives thereof. The first fluoride-containing monomer may have a side group that is an electron-donating group of -CH3, -OR, and -OCOCH3 and said second monomer is methyl methacrylate. The first fluoride-containing monomer may have a side group that is an electron-withdrawing group of -COOR, -CN, - COCH3 and said second monomer is styrene. The second monomer may be any of the monomers 2-(monofluoromethyl)prop-2-enenitrile, 2-(monofluoromethyl)prop-2-enoic acid, or 2-(monofluoromethyl)-3-methoxyprop-1-ene, 2-(difluoromethyl)prop-2-enenitrile, 2-(difluoromethyl)prop-2-enoic acid, or 2-(difluoromethyl)-3-methoxyprop-1-ene. The first monomer may be fluoroethylene vinyl ether, 3-[2-(trifluoromethyl)phenyl]prop-2-enenitrile or 2-fluoro-4-vinylbenzonitrile. The initiator may be an ionic initiator and selected from aluminum trichloride, titanium tetrachloride, boron trifluoride, or tin tetrachloride. The ionic initiator may be polystyryl lithium or n-butyl lithium. The polymer chain terminator may be dichloromethane. The ionic polymerization be performed with the first monomer being vinylidene fluoride. The weight percentage of the fluoride-containing first monomer is 1-50%. 22. The method according to claim 11-21, wherein the solvent is a mixture of any of the solvents acetonitrile, dimethyl formamide, tetrahydrofurane, or dimethylacetamide, and a fluoride-containing solvent from any of the solvents dichlorodifluoromethane, trichlorofluoroethane, perfluorooctyl bromide, or perfluorooctane.

In one example embodiment there is provided a nanoimprint system (2000) for nanoimprinting comprising: a provided substrate spin-coated with a nanoimprint resist; a mold, having a pattern, for contacting (104) with said nanoimprint resist; an UV light source; wherein said mold is configured for pressing 108 said mold into the nanoimprint resist and for release of said mold.

The nanoimprint system may comprise a UV light source. The mold pattern may be a nanostructured topological pattern in the range of 1-100 nm. The contacting of the mold with the nanoimprint resist may be performed by pressing or stamping the mold in contact with the nanoimprint resist. The nanoimprint system may be configured to radically crosslink the copolymer nanoimprint resist simultaneous with or following the contacting of the mold.

Although modifications and changes may be suggested by those skilled in the art, it is the intent of the inventor to,

within the scope of the disclosure herein, that the invention encompasses the scope of all modifications and modifications which reasonably and properly fall within the scope of the disclosure disclosed herein. The present invention has been described above with reference to specific embodiments. However, other embodiments than the above described are equally possible within the scope of the invention. Different method steps than those described above, may be provided within the scope of the invention. The different features and steps of the invention may be combined in other combinations than those described. For example, various features of embodiments may be combined in combinations other than those described mutatis mutandis. The scope of the invention is limited only by the appended claims.

## Claims

**1.** A nanoimprint resist (1) comprising:

a copolymer obtained from a monomer mixture comprising a first monomer and a second monomer, wherein the first monomer is a fluoride-containing monomer,
and, in the copolymer, the first monomer is a repeating unit by $n_1$, and the second monomer is a repeating unit by $n_2$.

**2.** The nanoimprint resist according to claim 1, wherein the first monomer is selected from the monomer group consisting of tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene and derivatives thereof.

**3.** The nanoimprint resist according to claim 1 or 2, wherein the second monomer is methyl methacrylate or a derivate of methyl methacrylate.

**4.** The nanoimprint resist according to any one of claims 1-3, wherein the copolymer is poly(chlorotrifluoroethylene)-graft-(methyl pyridinium)-block-poly(methyl methacrylate).

**5.** The nanoimprint resist according to any one of claims 1-4, wherein the first monomer is present in an amount of 1-10%, by weight of the nanoimprint resist.

**6.** The nanoimprint resist according to any one of claims 1-5, wherein the nanoimprint resist comprises a phot initiator.

**7.** The nanoimprint resist according to any one of claims 1-6, wherein the molecular weight of the copolymer is 120 kg $mol^{-1}$ or below.

**8.** A method of producing a nanoimprint copolymer resist (1), the method comprising:

providing (1001) a first and a second monomer, wherein the first monomer is a fluoride-containing monomer and the second monomer is methyl methacrylate or styrene;
providing (1002) an initiator;
initiating (1003) polymerization of a first polymer by the initiator with the first monomer;
initiating polymerization of a second polymer by the initiator with the second monomer; and,
mixing (1004) the propagated polymers with a polymer chain terminator.

**9.** The method according to claim 8, wherein the initiator is an ionic initiator and selected from the group consisting of aluminum trichloride, titanium tetrachloride, boron trifluoride, and tin tetrachloride.

**10.** The method according to claim 9, wherein the ionic initiator is polystyryl lithium or n-butyl lithium.

**11.** The method according to claim 9 or 10, wherein the polymer chain terminator is dichloromethane.

**12.** The method according to any one of claims 9-11, further comprising dissolving the first monomer, the second monomer, and the initiator in a solvent,
wherein the solvent is a mixture of:

at least one solvent selected from the gropup consisting of acetonitrile, dimethyl formamide, tetrahydrofurane,

and dimethylacetamide,
and at least one fluoride-containing solvent selected from the group consisting of dichlorodifluoromethane, trichlorofluoroethane, perfluorooctyl bromide, and perfluorooctane.

**13.** A nanoimprint system (2000) for nanoimprinting, the nanoimprint system comprising:

a substrate spin-coated with a nanoimprint resist according to any one of claims 1-7; and
a mold, having a pattern, for contacting (104) with said nanoimprint resist;
wherein the mold is configured for pressing (108) the mold in contact with the nanoimprint resist and for subsequent release of the mold from contact with the nanoimprint resist.

**14.** Nanoimprint system (2000) according to claim 13, further comprising a UV light source.

**15.** Nanoimprint system (2000) according to claim 13 or 14, wherein the pattern comprises a nanostructured topological pattern in the range of 1-100 nm.

**Amended claims in accordance with Rule 137(2) EPC.**

**1.** A nanoimprint resist comprising a copolymer obtained from a monomer mixture comprising a first monomer and a second monomer, wherein:

the first monomer is a fluoride-containing monomer,
the second monomer is methyl methacrylate or a derivate of methyl methacrylate,
in the copolymer, the first monomer is a repeating unit by $n_1$, and
in the copolymer, the second monomer is a repeating unit by $n_2$.

**2.** The nanoimprint resist according to claim 1, wherein the first monomer is selected from the monomer group consisting of tetrafluoroethylene, vinylidene fluoride, chlorotrifluoroethylene, hexafluoropropene, hexafluoroisobutylene, trifluoropropene, perfluoroalkylvinyl ethers, methyl trifluoroacrylate, perfluorobutadiene, trifluorostyrene, bromotrifluoroethylene and derivatives thereof.

**3.** The nanoimprint resist according to claim 1 or 2, wherein the copolymer is poly(chlorotrifluoroethylene)-graft-(methyl pyridinium)-block-poly(methyl methacrylate).

**4.** The nanoimprint resist according to any one of claims 1-3, wherein the first monomer is present in an amount of 1-10%, by weight of the copolymer.

**5.** The nanoimprint resist according to any one of claims 1-4, wherein the nanoimprint resist comprises a photoinitiator.

**6.** The nanoimprint resist according to any one of claims 1-5, wherein the weight average molecular weight of the copolymer is 120 kg $mol^{-1}$ or below.

**7.** A method of producing a copolymer for a nanoimprint resist, the method comprising:

providing a first monomer and a second monomer, wherein the first monomer is a fluoride-containing monomer and the second monomer is methyl methacrylate or derivate of methyl methacrylate;
providing an initiator;
initiating polymerization of a first polymer by the initiator with the first monomer;
initiating polymerization of a second polymer by the initiator with the second monomer; and,
mixing the propagated polymers with a polymer chain terminator to form the copolymer.

**8.** The method according to claim 7, wherein the initiator is an ionic initiator and selected from the group consisting of aluminum trichloride, titanium tetrachloride, boron trifluoride, and tin tetrachloride.

**9.** The method according to claim 8, wherein the ionic initiator is polystyryl lithium or n-butyl lithium.

**10.** The method according to claim 8 or 9, wherein the polymer chain terminator is dichloromethane.

**11.** The method according to any one of claims 8-10, further comprising dissolving the first monomer, the second monomer, and the initiator in a solvent,
wherein the solvent is a mixture of:

at least one solvent selected from the group consisting of acetonitrile, dimethyl formamide, tetrahydrofurane, and dimethylacetamide,
and at least one fluoride-containing solvent selected from the group consisting of dichlorodifluoromethane, trichlorofluoroethane, perfluorooctyl bromide, and perfluorooctane.

**12.** A nanoimprint system for nanoimprinting, the nanoimprint system comprising:

a substrate spin-coated with a nanoimprint resist according to any one of claims 1-6; and
a mold, having a pattern, for contacting with said nanoimprint resist;
wherein the mold is configured for pressing the mold in contact with the nanoimprint resist and for subsequent release of the mold from contact with the nanoimprint resist.

**13.** Nanoimprint system according to claim 12, further comprising a UV light source.

**14.** Nanoimprint system according to claim 12 or 13, wherein the pattern comprises a nanostructured topological pattern in the range of 1-100 nm.

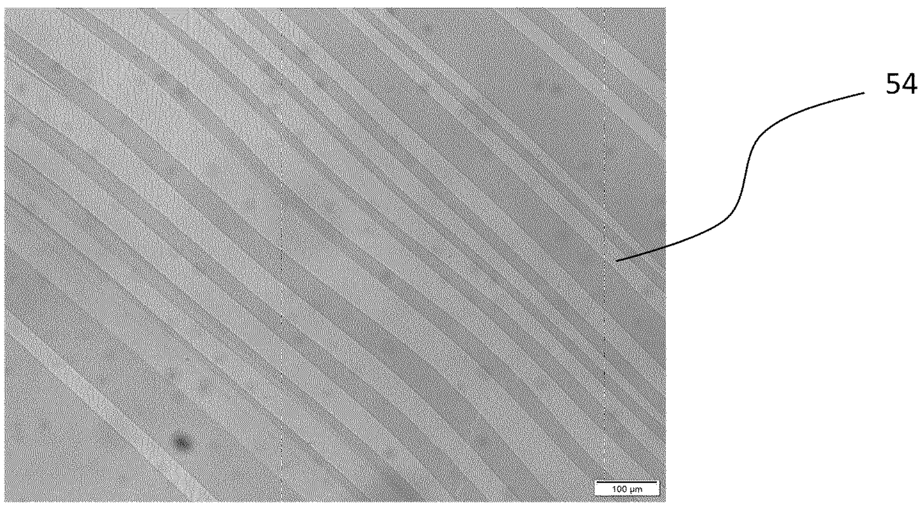


Figure 1

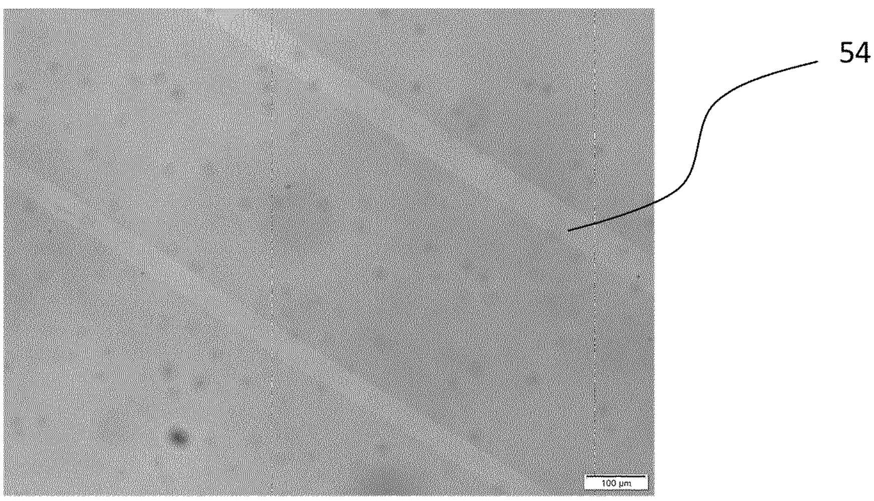


Figure 2

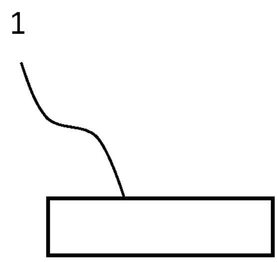


Figure 3

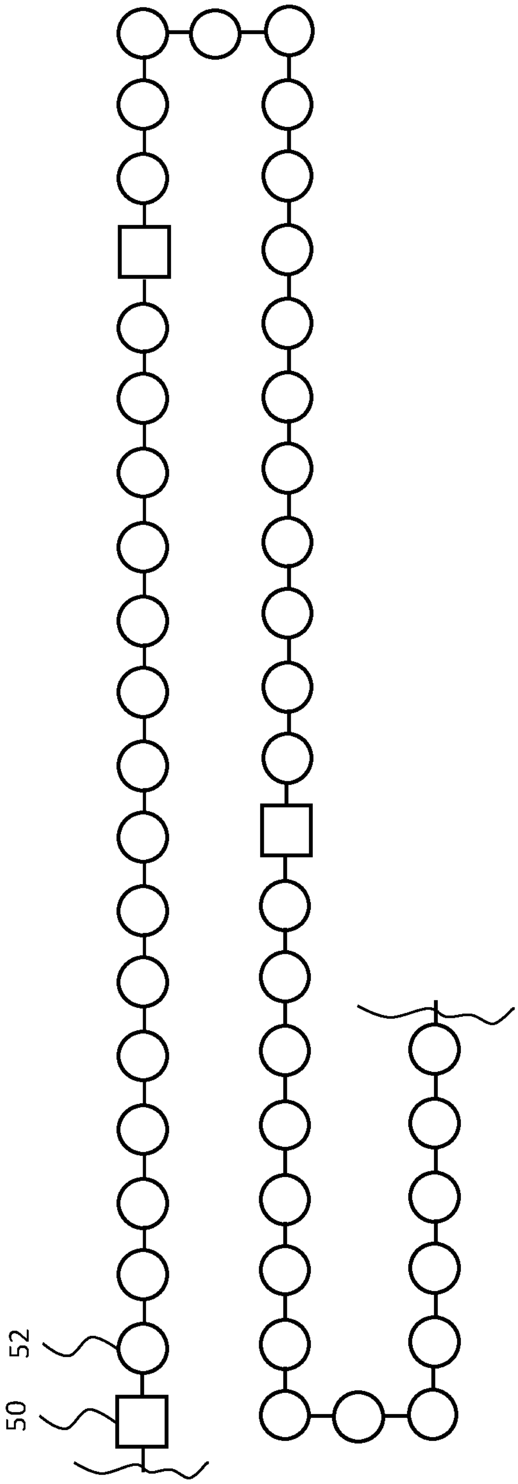


Figure 4

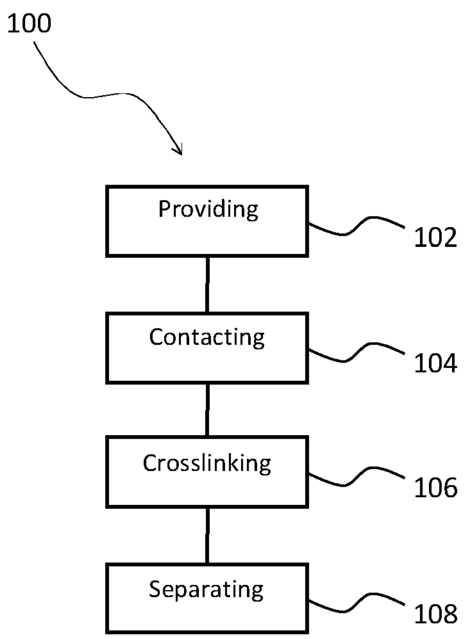


Figure 5

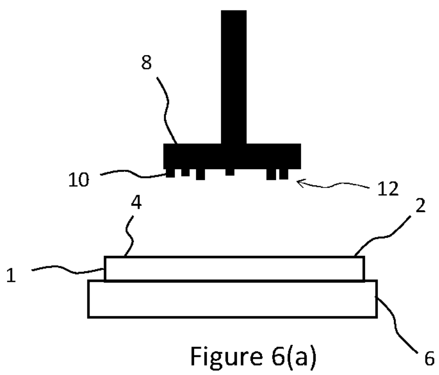


Figure 6(a)

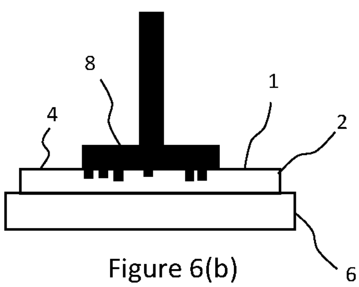


Figure 6(b)

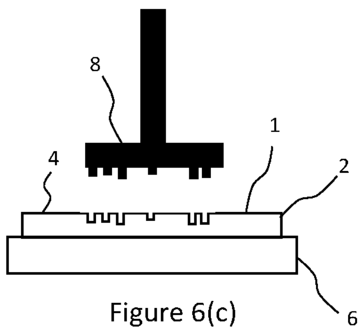


Figure 6(c)

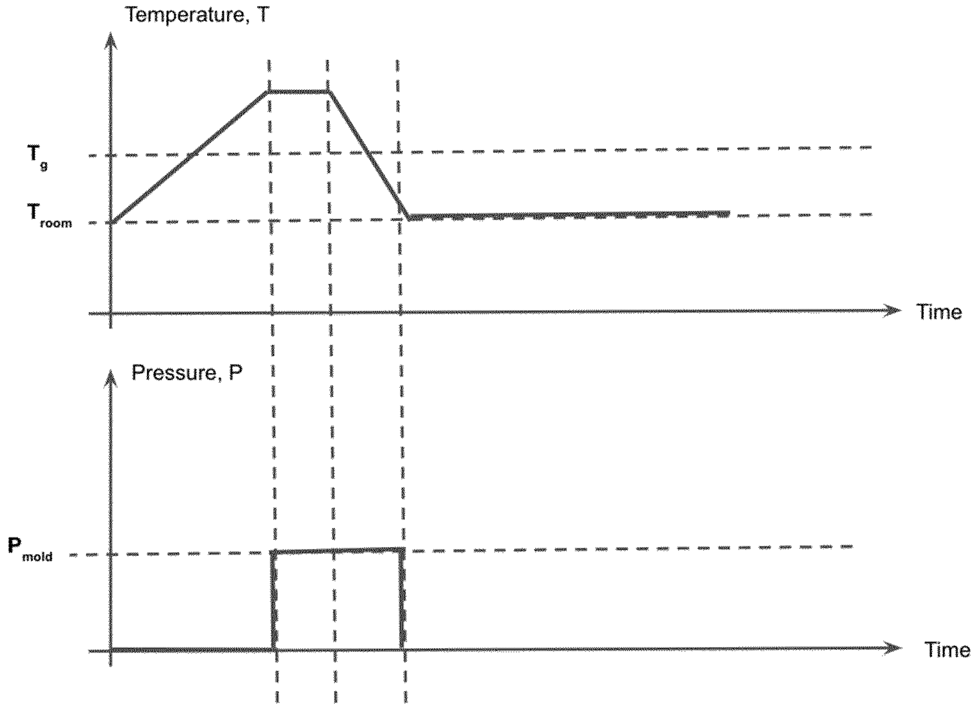


Figure 7(a)

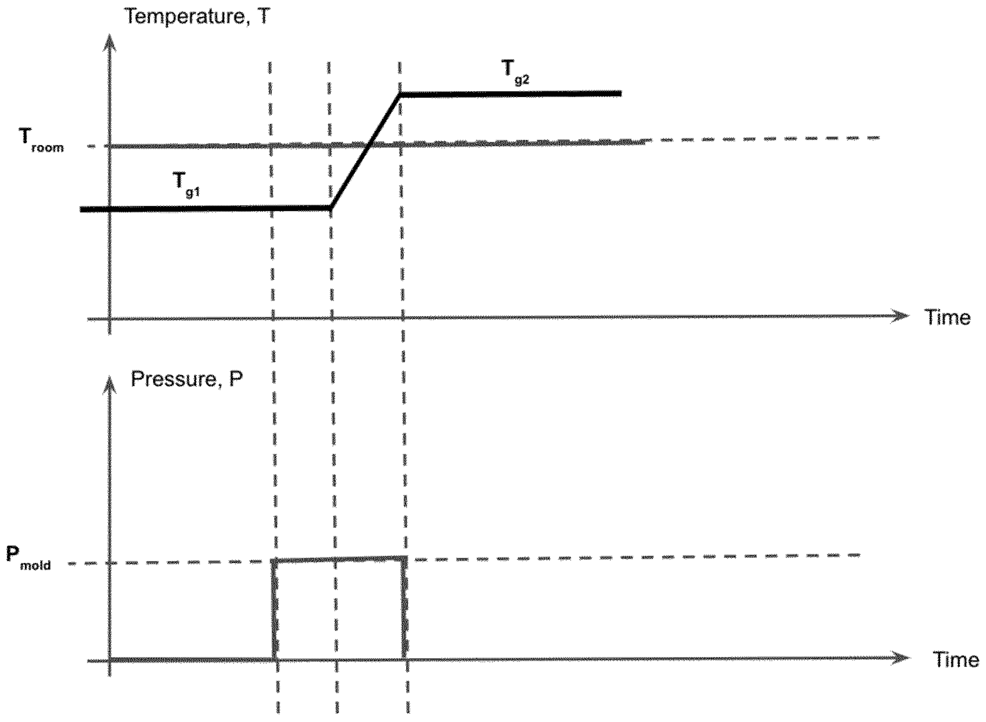


Figure 7(b)

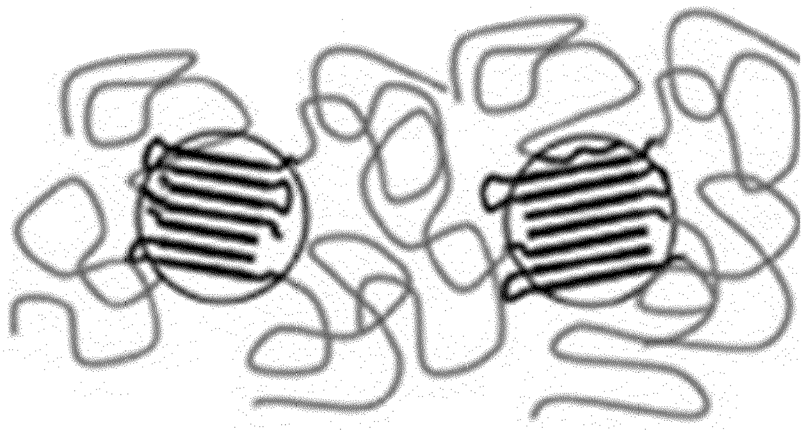

Figure 8(a)

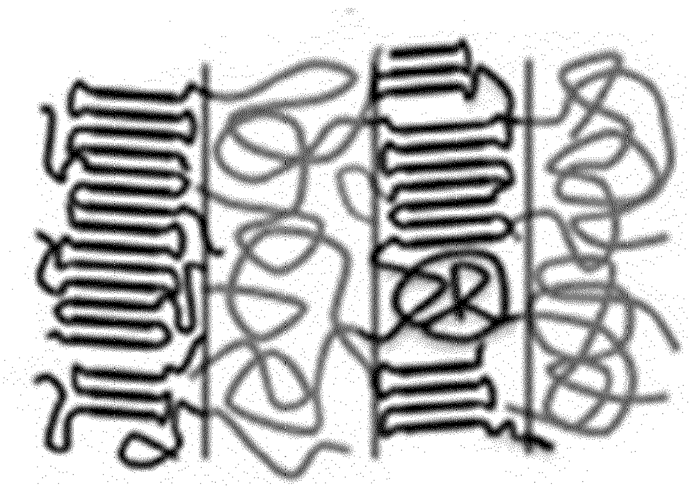

Figure 8(b)

Europäisches Patentamt
European Patent Office
Office européen des brevets

# EUROPEAN SEARCH REPORT

Application Number
EP 24 19 8911

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ZAPSAS GEORGE ET AL: "Poly(vinylidene fluoride)-based complex macromolecular architectures: From synthesis to properties and applications", PROGRESS IN POLYMER SCIENCE, PERGAMON PRESS, OXFORD, GB, vol. 104, 29 February 2020 (2020-02-29), XP086149604, ISSN: 0079-6700, DOI: 10.1016/J.PROGPOLYMSCI.2020.101231 [retrieved on 2020-02-29] * the whole document * ----- | 1-7, 13-15 | INV. G03F7/00 G03F7/004 |
| X<br>A | JP 2010 106062 A (FUJIFILM CORP) 13 May 2010 (2010-05-13) * polymers C1 , C4 to C7 and X1; paragraphs [0098] - [0122]; claims 1-13; examples 1,4-12; tables 1-3 * ----- | 1,6,7, 13-15<br>2-5 | |
| X<br>A | US 2015/064909 A1 (YAMASHITA TSUNEO [JP] ET AL) 5 March 2015 (2015-03-05) * preparation examples 1-42, composition examples 1-26; paragraphs [0137] - [0228], [0302] - [0334]; claims 1-31; tables 1-3 * ----- | 1,6,7, 13-15<br>2-5 | TECHNICAL FIELDS SEARCHED (IPC)<br>G03F |

~~The present search report has been drawn up for all claims~~

1

| Place of search | Date of completion of the search | Examiner |
|---|---|---|
| The Hague | 25 February 2025 | Eggers, Karin |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

Application Number
EP 24 19 8911

## CLAIMS INCURRING FEES

The present European patent application comprised at the time of filing claims for which payment was due.

- [ ] Only part of the claims have been paid within the prescribed time limit. The present European search report has been drawn up for those claims for which no payment was due and for those claims for which claims fees have been paid, namely claim(s):

- [ ] No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

- [ ] All further search fees have been paid within the fixed time limit. The present European search report has been drawn up for all claims.

- [ ] As all searchable claims could be searched without effort justifying an additional fee, the Search Division did not invite payment of any additional fee.

- [ ] Only part of the further search fees have been paid within the fixed time limit. The present European search report has been drawn up for those parts of the European patent application which relate to the inventions in respect of which search fees have been paid, namely claims:

- [x] None of the further search fees have been paid within the fixed time limit. The present European search report has been drawn up for those parts of the European patent application which relate to the invention first mentioned in the claims, namely claims:

  1-7, 13-15

- [ ] The present supplementary European search report has been drawn up for those parts of the European patent application which relate to the invention first mentioned in the claims (Rule 164 (1) EPC).

Europäisches Patentamt
European Patent Office
Office européen des brevets

# LACK OF UNITY OF INVENTION SHEET B

Application Number
EP 24 19 8911

The Search Division considers that the present European patent application does not comply with the requirements of unity of invention and relates to several inventions or groups of inventions, namely:

1. claims: 1-7, 13-15

A nanoimprint resist comprising a copolymer containing a repeating unit derived from a fluorine-containing monomer

---

2. claims: 8-12

A method for producing two polymers wherein one of the synthesised polymers comprises a repeating unit of a fluorine-containing monomer

---

## ANNEX TO THE EUROPEAN SEARCH REPORT ON EUROPEAN PATENT APPLICATION NO.

EP 24 19 8911

This annex lists the patent family members relating to the patent documents cited in the above-mentioned European search report. The members are as contained in the European Patent Office EDP file on
The European Patent Office is in no way liable for these particulars which are merely given for the purpose of information.

25-02-2025

| Patent document cited in search report | Publication date | Patent family member(s) | Publication date |
|---|---|---|---|
| JP 2010106062 A | 13-05-2010 | NONE | |
| US 2015064909 A1 | 05-03-2015 | CN 104220224 A | 17-12-2014 |
| | | JP 5794387 B2 | 14-10-2015 |
| | | JP WO2013154112 A1 | 17-12-2015 |
| | | KR 20140133929 A | 20-11-2014 |
| | | US 2015064909 A1 | 05-03-2015 |
| | | WO 2013154112 A1 | 17-10-2013 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description


- *Journal of Vacuum Science & Technology B*, 2007, vol. 25 (6), 2430-2434
- *Nanotechnology*, 2016, vol. 27, 155301
- *Journal of Vacuum Science & Technology B: Microelectronics and Nanometer Structures Processing, Measurement, and Phenomena.*, 2007, vol. 25, 2430
- *J. APPL. POLYM. SCI.*, 2015